# EUROPEAN PATENT APPLICATION

(11) **EP 3 263 576 A1**
(43) Date of publication of application: **03.01.2018**
(21) Application number: 17173316.5
(22) Date of filing: 29.05.2017
(51) Int. Cl.: C07F 9/6593, B32B 15/00, H05K 1/00

(54) **PHOSPHAZENE COMPOUND CONTAINING ESTER GROUP, PREPARATION METHOD AND USE THEREOF**

(30) Priority: 29.06.2016 CN 201610508630
(71) Applicant: Guangdong Guangshan New Materials Co., Ltd., Guangdong 523000 (CN)
(72) Inventor: PAN, Qingchong, GUANGDONG, Guangdong 523000 (CN)
(74) Representative: Weber, Jean-François

(57) **Abstract**

The present invention relates to a phosphazene compound containing an ester group having a structure of formula (I). The present invention grafts ester groups to phosphazene compounds and makes terminal grafted hydroxyl and carboxyl groups reacted with polymer matrix, producing an improvement of flame retardancy and a reduction of dielectric constant at the same time when the phosphazene compound is introduced into polymer matrix. Since N and P atoms are directly bonded into the polymer matrix by a reaction rather than addition and combination means in the prior art, there is no reduced mechanical properties of the matrix due to the addition of flame retardants.

## Description

### Technical field

The present invention belongs to the technical field of phosphazene compounds, in particular relates to a phosphazene compound containing ester group, a preparation method and a use thereof on composite metal substrates.

### Background art

For the purpose of safety, electronic products represented by mobile phones, computers, video cameras and electronic game machines, household and office electrical products represented by air conditioners, refrigerators, television images, audio products etc., and various products used in other areas mostly require different degrees of flame retardancy.

In order to make the products achieve required flame retardant performance or grade, traditional techniques often utilize the following means: adding inorganic flame retardant materials such as metal hydroxides containing crystal water, for example, aluminum hydroxide hydrate, magnesium hydroxide hydrate, and others, into a material system; and adding organic chemicals having a high content of bromine or halogen, such as brominated bisphenol A, brominated bisphenol A epoxy resin and others into a material system. In order to improve the flame retardancy of these organic chemicals containing halogen, environmentally unfriendly inorganic chemical flame retardants such as antimony trioxide and others are often added into the system.

The copper-clad laminates produced by using phosphorus-containing phenolic aldehyde as a part or all of the flame retardant ingredients can achieve flame retardancy. However, there are many defects in acid and alkali resistance, chemical resistance, cohesiveness, heat resistance, processability and so on, so that they cannot meet the demands of high multilayer, high reliability, high cohesiveness and good processability for manufacturing modem communications. In addition, due to high cost, it is disadvantageous for them to spread to civilian goods fields such as consumer electronics demanding low cost, for example cell phones.

With further improvement of demands for shortness, smallness, thinness, high multilayer and high reliability in the electronic industry, popularization of civilian consumer electronics, and more and more serious pressure of environmental pollution, there is an urgent market demand for cheap flame retardant substances having good flame retardancy, heat resistance and good mechanical properties.

### Contents of the Invention

Aiming at the problems in the prior art, the first object of the present invention lies in providing a phosphazene compound containing ester group, which has a structure of formula (I): 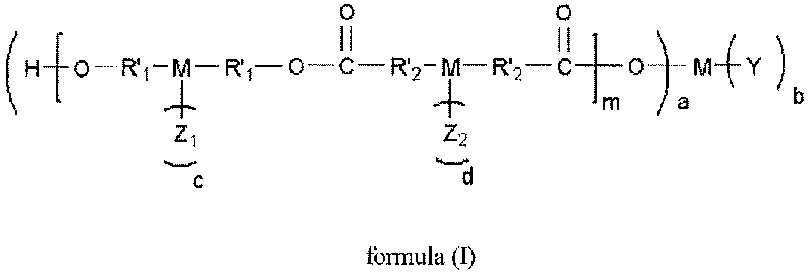
wherein, Y, Z₁ and Z₂ are inert nucleophilic groups;
M is any one of phosphazene compounds or a combination of at least two of them;
R'₁ is -X-R'₃-; R'₂ is -X-R'₄-; R'₃ and R'₄ are organic groups having two broken bonds; X is oxygen atom, nitrogen atom or sulfur atom;
a is an integer greater than or equal to 1, such as 1, 2, 3, 4, 5, 6, 7, 8, 9, 10, 11, 14, 15, and so on; b is an integer greater than or equal to 0, such as 0, 1, 2, 3, 4, 5, 6, 7, 8, 9, 10, 13, 15, and so on; c is an integer greater than or equal to 0, such as 0, 1, 2, 3, 4, 5, 6, 7, 8, 9, 10, 13, 15, and so on; d is an integer greater than or equal to 0, such as 0, 1, 2, 3, 4, 5, 6, 7, 8, 9, 10, 13, 15, and so on; the sum of b and a is two times of the number of phosphorus atoms in M; the sum of c+2 is two times of the number of phosphorus atoms in M; the sum of d+2 is two times of the number of phosphorus atoms in M; m is an integer less than or equal to 10, such as 1, 2, 3, 4, 5, 6, 7, 8, 9, and so on.

A phosphazene compound containing ester group has a structure of formula (II): 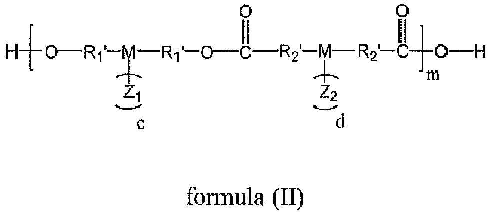
wherein, Z₁ and Z₂ are inert nucleophilic groups;
M is any one of phosphazene compounds, or a combination of at least two of them;
R'₁ is -X-R'₃-; R'₂ is -X-R'₄-; R'₃ and R'₄ are organic groups having two broken bonds; X is oxygen atom, nitrogen atom or sulfur atom;
c is an integer greater than or equal to 0, such as 0, 1, 2, 3, 4, 5, 6, 7, 8, 9, 10, 13, 15, and so on; d is an integer greater than or equal to 0, such as 0, 1, 2, 3, 4, 5, 6, 7, 8, 9, 10, 13, 15, and so on; the sum of c+2 is two times of the number of phosphorus atoms in M; the sum of d+2 is two times of the number of phosphorus atoms in M; m is an integer greater than 0 and less than or equal to 10, such as 1, 2, 3, 4, 5, 6, 7, 8, 9, and so on.

The present invention grafts ester groups to phosphazene compounds and makes terminal grafted hydroxyl and carboxyl groups reacted with polymer matrix, producing an improvement of flame retardancy and a reduction of dielectric constant at the same time when the phosphazene compound is introduced into polymer matrix. Since N and P atoms are directly bonded into the polymer matrix by a reaction rather than addition and combination means in the prior art, there is no reduced mechanical properties of the matrix due to the addition of flame retardants.

In the present invention, "inert nucleophilic group" means a group which is able to carry out nucleophilic reaction, by which the group is bonded on a phosphazene matrix M (for example cyclotriphosphazene, cyclotetraphosphazene, or linear phosphazene) and then no longer has reaction activity; "reaction activity" refers to an ability to carry out any of known reactions in the art, including nucleophilic substitution, addition reaction, acid-base reaction, esterification reaction, displacement reaction, etc.

The phosphazene compound containing ester group of the present invention is obtained by esterification reaction of a phosphazene compound monomer having at least two hydroxyl groups and a phosphazene compound monomer having at least two carboxyl groups.

Those skilled in the art should appreciate that hydroxyl groups and carboxyl groups are needed for esterification. In the present invention, phosphazene matrix can connect with a plurality of hydroxyl groups or carboxyl groups, and any two groups of hydroxyl and carboxyl can carry out esterification reaction in the process of esterification, forming the phosphazene compound of the present invention.

In the present invention, phosphazene compound monomers having hydroxyl groups and phosphazene compound monomers having carboxyl groups are also likely to form a network shape compound or a compound having side chain(s), and the obtained products thereof fall within the protection scope of the present invention.

Preferably, Z₁ and Z₂ in the present invention are independently selected from any one of -OR₁₄, - SR₂, 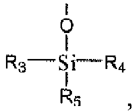 -C≡C-R_{6,} 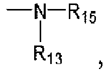 -O-NO₂, -I or 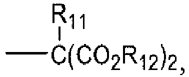 or a combination of at least two of them.

Wherein, R₁₄, R₁₃, R₂, R₃, R₄, R₅, R₆, R₁₅, R₁₁ and R₁₂ are independently any one of substituted or unsubstituted linear alkyl or branched alkyl, substituted or unsubstituted cycloalkyl, substituted or unsubstituted aralkyl, substituted or unsubstituted alkoxy, substituted or unsubstituted alkylthio group, substituted or unsubstituted cycloalkoxy, substituted or unsubstituted arylalkoxy, substituted or unsubstituted alkylaryloxy, substituted or unsubstituted carbonate group, substituted or unsubstituted sulfonate group, substituted or unsubstituted phosphonate group, substituted or unsubstituted aryl, or substituted or unsubstituted heteroaryl.

Preferably, M is selected from cyclic phosphazene having a structure of formula (III), or linear phosphazene having a structure of formula (IV); 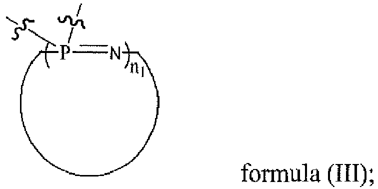 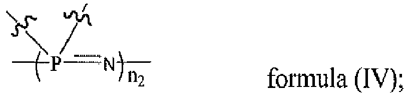 in formula (III) or formula (IV), n₁ and n₂ are independently selected from integers of 3-10; n₁ is preferably 3 or 4, and n₂ is preferably 5, 6, 7 or 8.

M can be selected as cyclic phosphazene, such as cyclotriphosphazene and/or cyclotetraphosphazene, and can also be selected as linear phosphazene, the linear phosphazene having P=N as repeating units and being terminated by hydrogen atom or methyl. The P atoms of M are at least grafted by -X-Y, and optionally grafted by R, achieving the purpose of grafting coupling agent group to M.

Preferably, M is any one of cyclotriphosphazene group M₁, cyclotetraphosphazene group M₂ or non-cyclic polyphosphazene group M₃, or a combination of at least two of them. Preferably, R'₃ is selected from substituted or unsubstituted hydrocarbylene, and preferably selected from substituted or unsubstituted linear alkylene, substituted or unsubstituted branched alkylene, substituted or unsubstituted arylene; more preferably C₁-C₃₀ substituted or unsubstituted linear alkylene, C₃-C₃₀ substituted or unsubstituted branched alkylene, and C₆-C₃₀ substituted or unsubstituted arylene; in particular preferably C₁-C₁₀ substituted or unsubstituted linear alkylene, C₁-C₁₀ substituted or unsubstituted branched alkylene, and C₆-C₁₆ substituted or unsubstituted arylene; in particular preferably phenylene, methylphenylene, dimethylphenylene, ethylphenylene, 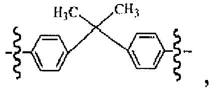 methylene, ethylene, propylene, n-butylene, or isopropylene.

Preferably, the phosphazene compound containing ester group is obtained by esterification reaction of a phosphazene compound monomer having at least two hydroxyl groups and a phosphazene compound monomer having at least two carboxyl groups.

Preferably, the phosphazene compound containing ester group comprises any one of the phosphazene compounds having the following structures, or a mixture of at least two of them: 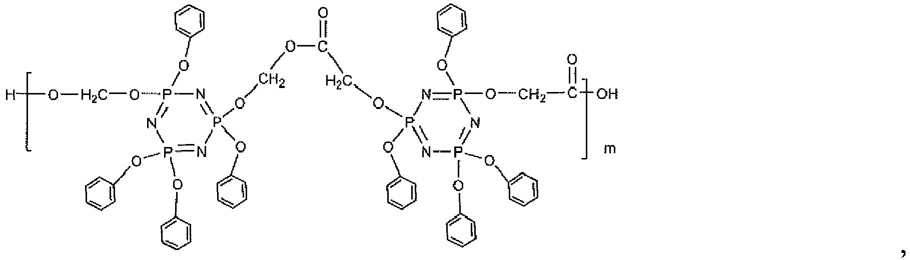 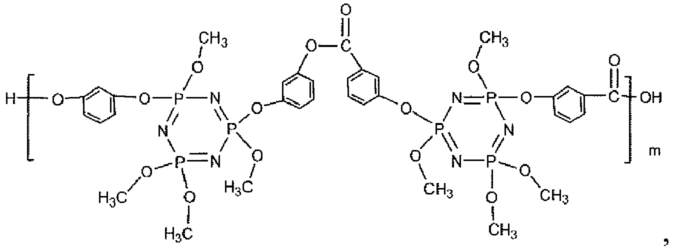 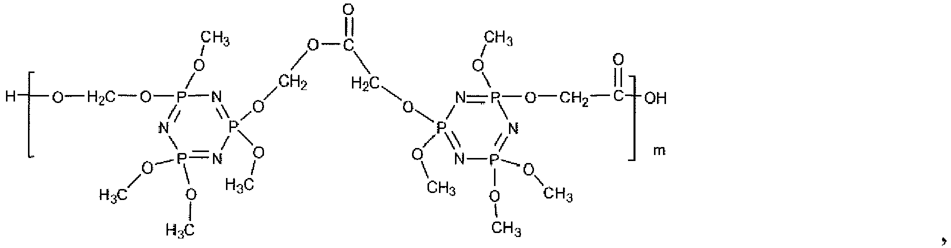 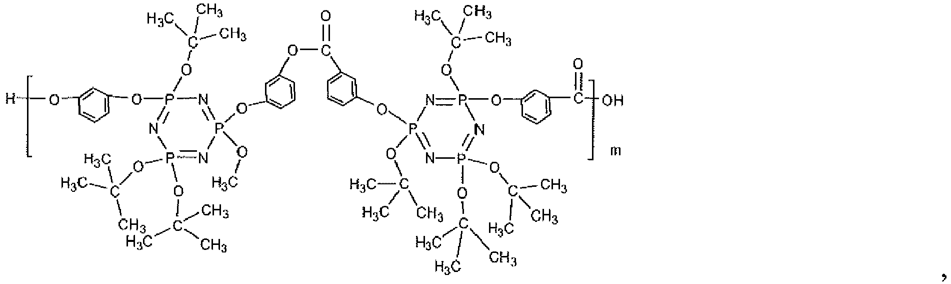 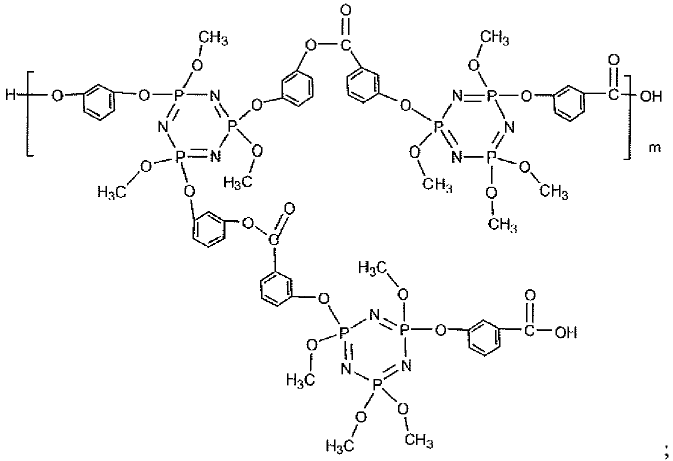 wherein m is an integer greater than 0 and less than or equal to 10.

The second object of the present invention is to provide a method for preparing the phosphazene compound containing ester group stated in the first object, comprising the following steps:
(1) carrying out a nucleophilic reaction of phosphazene chloride M(̵Cl)_{c+2} with an inert nucleophile, thereby replacing partial chlorine atoms on M by inert nucleophilic groups, with two remaining chlorine atoms on the phosphazene chloride being not replaced;
(2) dividing the product obtained in step (1) into two equal parts in mole, with one part being reacted with H-X-R'₃-OH to relapce the remaining chlorine atoms on phosphazene matrix by -R'₁-OH, and the other part being reacted with H-X-R'₄-COOH to replace the remaining chlorine atoms on phosphazene matrix by -R'₂-COOH;
(3) carrying out esterification reaction of the phosphazene compound having hydroxyl groups with the phosphazene compound having carboxyl groups obtained in step (2), thereby obtaining a phosphazene compound containing ester group;
wherein M, X, R'₁, R'₂, R'₃ and R'₄ have scopes as defined in the first object.

Those skilled in the art should appreciate that phosphazene matrix has one or more phosphorus atoms, and each phosphorus atom can be grafted with two side-chain groups. During steps (1) and (2) of the above preparation process, each chlorine atom has an opportunity that is almost identical to be substituted. Therefore, in the reaction process, it is unable to control completely the number and position of the substituents, and thus the product obtained by the above method is often a mixture. But all these mixtures can be used for the esterification reaction of the present invention, which follows the principle that it is carried out by the reaction of hydroxyl and carboxyl groups. Of course, under the premise of ensuring the proportion of materials, most of the products should be obtained in accordance with the designed solution.

In the chemical structures, the substituents are not shown connecting to a certain atom of cyclotriphosphazene, but drafted toward the inside of the ring of cyclotriphosphazene, which means that the substituents can be at any position of the cyclotriphosphazene under the premise of satisfying the demand of valence state.

The third object of the present invention is to provide a resin composition comprising the phosphazene compound containing ester group of the first object.

The fourth object of the present invention is to provide a prepreg prepared by impregnating a substrate with the resin composition of the third object or coating the resin composition of the third object onto a substrate.

Preferably, the substrate is a glass fiber substrate, a polyester substrate, a polyimide substrate, a ceramic substrate or a carbon fiber substrate.

The fifth object of the present invention is to provide a composite metal laminate comprising at least one sheet of the prepreg described in the fourth object and prepared by coating metal layer on the surface of the prepregs, overlapping and pressing successively,

Preferably, the material of the surface-coating metal layer is aluminium, copper, iron and alloys of any combination thereof.

Preferably, the composite metal laminate is CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

The sixth object of the present invention is to provide a wiring board prepared by processing wirings on the surface of the composite metal laminate as described in the fifth object.

The seventh object of the present invention is to provide a flexible copper-clad laminate, which comprises at least one prepreg as mentioned in the fourth object and copper foil overlaying at one side or both sides of the superimposed prepregs.

The eighth object of the present invention is to provide a use of the phosphazene compound containing ester group described in the first object, which is used in IC package board, HDI package board, automotive board or copper-clad laminate.

Compared with the prior art, the present invention has the following beneficial effects:
The present invention grafts ester groups to phosphazene compounds and makes terminal grafted hydroxyl and carboxyl groups reacted with polymer matrix, producing an improvement of flame retardancy and a reduction of dielectric constant at the same time when the phosphazene compound is introduced into polymer matrix. Since N and P atoms are directly bonded into the polymer matrix by a reaction rather than addition and combination means in the prior art, there is no reduced mechanical properties of the matrix due to the addition of flame retardants.

### Embodiments

In order to facilitate the understanding of the present invention, examples are listed as follows. Those skilled in the art should appreciate that the embodiments are only used to understand the present invention and shall not be deemed as limitations to the present invention.

In order to describe the structure and method expediently, specific positions of substituents in the phosphazene compounds obtained by the examples of the present invention are not marked, and this means that the substituents can be at any position. In addition, the number of substituents in the structure of the compound described in each example only an illustration of the product prepared by the method, and the number of substituents is the average value of the substituents in the product and does not mean that the product is a compound just having one specific structure.

### Example 1

A phosphazene compound containing ester group, having the following structure: 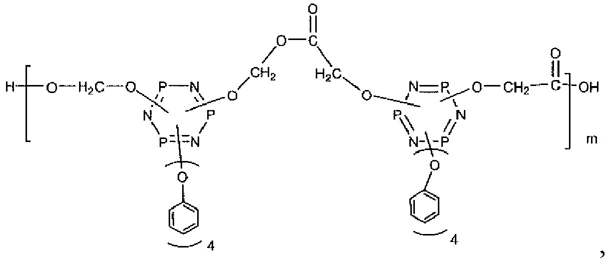 wherein cyclotriphosphazene is substituted by four phenoxyl groups on average, and m is 3.

The preparation method thereof is as follow:
(1) 1 mol of hexachlorocyclotriphosphazene, 200 ml of acetone, 4 mol of sodium phenate were added to a 3-neck glass reactor having a volume of 2000 ml and equipped with a stirring apparatus. While stirring, nitrogen was fed therein, and the reactor was heated to 60°C. 20% sodium hydroxide solution was dripped therein taking 60 min to make pH neutral, and then the mixture was held at 60°C, stirred and reacted for 15 hours;
(2) The product of step (1) was divided into two equal parts;
   One part was reacted with 2 mol of methylene glycol. While stirring, nitrogen was fed therein, and the reactor was heated to 40°C. 20% sodium hydroxide solution was dripped therein taking 30 min to make pH neutral, and then the mixture was held at 40°C, stirred and reacted for 15 hours. Then a phosphazene compound containing hydroxymethyloxyl group was obtained;
   The other part was reacted with 2 mol of 2-glycolic acid. While stirring, nitrogen was fed therein, and the reactor was heated to 40°C. 20% sodium hydroxide solution was dripped therein taking 30 min to make pH neutral, and then the mixture was held at 40°C, stirred and reacted for 15 hours. Then a phosphazene compound containing carboxyethyloxyl group was obtained;
(3) An esterification reaction of the phosphazene compound containing hydroxymethyloxyl group and the phosphazene compound containing carboxyethyloxyl group obtained in step (2) was carried out, so as to obtain a phosphazene compound containing ester group.

After reaction, the inorganic constituents and water in the system were removed by physical method; and the solvent in the system was removed by distillation; and thereby a phosphazene compound containing ester group was obtained.

The obtained phosphazene compound containing ester group was characterized by nuclear magnetic resonance hydrogen spectrum, and the results are as follows:
¹H NMR (CDCl₃, 500 MHz):6.7-6.8, 7.0-7.15, 6.8-6.9 (hydrogen on benzene ring), 5.75-5.80 (hydrogen on O-C-O), 6.30-6.35 (hydrogen on O-C-O-C=O), 4.45-4.55 (hydrogen on O=C-C-O), 11.0 (hydrogen on carboxyl group), 2.0 (hydrogen on hydroxyl group).

Characteristic peak positions in infrared spectroscopy: characteristic absorption peak of P=N in phosphazene skeleton, 1217 cm⁻¹; P-N in phosphazene skeleton, 874 cm⁻¹; absorption peak of P-O-C, 1035 cm⁻¹; skeleton vibration of benzene ring, 1500∼1600 cm⁻¹; absorption peak of ester group, 1200-1300 cm⁻¹.

An epoxy resin composition is prepared by adding 100 g of the above phosphazene compound containing ester group as a coupling curing agent to 100 g of o-cresol novolac epoxy resin with an epoxide equivalent of 200 g/eq and 0.1 g of 2-methylimidazole as a curing accelerator. A copper-clad laminate sample meeting the national, UL and other standards is prepared using the epoxy resin composition according to generally used copper-clad laminate production process. The copper-clad laminate is named as copper-clad laminate a and the properties thereof are measured and the results are shown in table 1.

### Example 2

A phosphazene compound containing ester group, having the following structure: 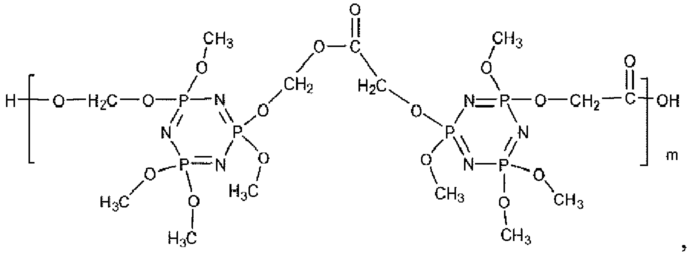 wherein cyclotriphosphazene is substituted by four methoxyl groups on average, and m is 2.

The preparation method thereof is as follow:
(1) 1 mol of hexachlorocyclotriphosphazene, 200 ml of acetone, 4 mol of sodium methoxide were added to a 3-neck glass reactor having a volume of 2000 ml and equipped with a stirring apparatus. While stirring, nitrogen was fed therein, and the reactor was heated to 60°C. 20% sodium hydroxide solution was dripped therein taking 60 min to make pH neutral, and then the mixture was held at 60°C, stirred and reacted for 15 hours;
(2) The product of step (1) was divided into two equal parts;
   One part was reacted with 2 mol of methylene glycol. While stirring, nitrogen was fed therein, and the reactor was heated to 40°C. 20% sodium hydroxide solution was dripped therein taking 30 min to make pH neutral, and then the mixture was held at 40°C, stirred and reacted for 15 hours. Then a phosphazene compound containing hydroxymethyloxyl group was obtained;
   The other part was reacted with 2 mol of 2- glycolic acid. While stirring, nitrogen was fed therein, and the reactor was heated to 40°C. 20% sodium hydroxide solution was dripped therein taking 30 min to make pH neutral, and then the mixture was held at 40°C, stirred and reacted for 15 hours. Then a phosphazene compound containing carboxyethyloxyl group was obtained;
(3) An esterification reaction of the phosphazene compound containing hydroxymethyloxyl group and the phosphazene compound containing carboxyethyloxyl group obtained in step (2) was carried out, so as to obtain a phosphazene compound containing ester group.

The obtained phosphazene compound containing ester group was characterized by nuclear magnetic resonance hydrogen spectrum, and the results are as follows:
¹H NMR (CDCl₃, 500 MHz): 5.75-5.80 (hydrogen on O-C-O), 6.30-6.35 (hydrogen on O-C-O-C=O), 4.45-4.55 (hydrogen on O=C-C-O), 11.0 (hydrogen on carboxyl group), 2.0 (hydrogen on hydroxyl group), 3.35 (hydrogen on methyl group).

Characteristic peak positions in infrared spectroscopy: characteristic absorption peak of P=N in phosphazene skeleton, 1217 cm⁻¹; P-N in phosphazene skeleton, 874 cm⁻¹; absorption peak of P-O-C, 1035cm⁻¹; stretching vibration of C-H in hydrocarbyl group, 2850-3000 cm⁻¹; stretching vibration of C=O, 1680-1630 cm⁻¹; absorption peak of ester group, 1200-1300 cm⁻¹.

An epoxy resin composition is prepared by adding 100 g of the above phosphazene compound containing ester group as a coupling curing agent to 100 g of o-cresol novolac epoxy resin with an epoxide equivalent of 200 g/eq and 0.1 g of 2-methylimidazole as a curing accelerator. A copper-clad laminate sample meeting the national, UL and other standards is prepared using the epoxy resin composition according to generally used copper-clad laminate production process. The copper-clad laminate is named as copper-clad laminate b and the properties thereof are measured and the results are shown in table 1.

### Example 3

A phosphazene compound containing ester group, having the following structure: 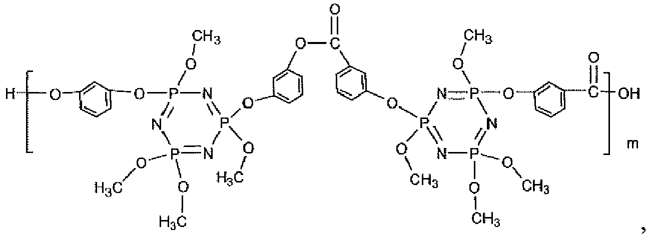 wherein cyclotriphosphazene is substituted by four methoxyl groups on average, and m is 10.

The preparation method thereof is as follow:
(1) 1 mol of hexachlorocyclotriphosphazene, 200 ml of acetone, 4 mol of sodium methoxide were added to a 3-neck glass reactor having a volume of 2000 ml and equipped with a stirring apparatus. While stirring, nitrogen was fed therein, and the reactor was heated to 60°C. 20% sodium hydroxide solution was dripped therein taking 60 min to make pH neutral, and then the mixture was held at 60°C, stirred and reacted for 15 hours;
(2) The product of step (1) was divided into two equal parts;
   One part was reacted with 2 mol of resorcin. While stirring, nitrogen was fed therein, and the reactor was heated to 60°C. 20% sodium hydroxide solution was dripped therein taking 30 min to make pH neutral, and then the mixture was held at 60°C, stirred and reacted for 15 hours. Then a phosphazene compound containing hydroxyphenyloxyl group was obtained;
   The other part was reacted with 2 mol of m-hydroxybenzoic acid. While stirring, nitrogen was fed therein, and the reactor was heated to 60°C. 20% sodium hydroxide solution was dripped therein taking 30 min to make pH neutral, and then the mixture was held at 60°C, stirred and reacted for 15 hours. Then a phosphazene compound containing carboxyl group was obtained;
(3) An esterification reaction of the phosphazene compound containing hydroxyphenyloxyl group and the phosphazene compound containing carboxyl group obtained in step (2) was carried out, so as to obtain a phosphazene compound containing ester group.

The obtained phosphazene compound containing ester group was characterized by nuclear magnetic resonance hydrogen spectrum, and the results are as follows:
¹H NMR (CDCl₃, 500 MHz): 6.15-6.25, 6.90-7.05 (hydrogen on HO-O-Ar-O-P), 7.65-7.75, 7.20-7.50 (hydrogen on O-Ar-C=O), 3.39 (hydrogen on methyl group), 6.6-6.8,7.1-7.7 (hydrogen on Ar-O-C(=O)-Ar).

Characteristic peak positions in infrared spectroscopy: characteristic absorption peak of P=N in phosphazene skeleton, 1217 cm⁻¹; P-N in phosphazene skeleton, 874 cm⁻¹; absorption peak of P-O-C, 1035cm⁻¹; stretching vibration of C-H in hydrocarbyl group, 2850-3000 cm⁻¹; stretching vibration of C=O, 1680-1630 cm⁻¹; absorption peak of ester group, 1200-1300 cm⁻¹.

An epoxy resin composition is prepared by adding 100 g of the above phosphazene compound containing ester group as a coupling curing agent to 100 g of o-cresol novolac epoxy resin with an epoxide equivalent of 200 g/eq and 0.1 g of 2-methylimidazole as a curing accelerator. A copper-clad laminate sample meeting the national, UL and other standards is prepared using the epoxy resin composition according to generally used copper-clad laminate production process. The copper-clad laminate is named as copper-clad laminate c and the properties thereof are measured and the results are shown in table 1.

### Comparative example 1

200 g of o-cresol novolac epoxy resin having an epoxide equivalent of 200 g/eq was added to 105 g of linear phenolic resin curing agent having a phenolic hydroxyl equivalent of 105g/eq, 70 g of hexaphenoxycyclotriphosphazene as a flame retardant and 0.2 g of 2-methylimidazol, and the mixture was dissolved into solution using an appropriate amount of butanone. A copper-clad laminate d with a resin content of 50% was prepared by using standard glass cloths according to a generally used production process. The properties of copper-clad laminate d are shown in table 1.

### Comparative example 2

200 g of o-cresol novolac epoxy resin having an epoxide equivalent of 200 g/eq was added to 220 g of a resin compound having a structure of formula (1), 70 g of hexaphenoxycyclotriphosphazene having an ester equivalent of 220g/eq as a flame retardant and 0.2 g of pyridine, and the mixture was dissolved into solution using an appropriate amount of butanone. A copper-clad laminate e with a resin content of 50% was prepared by using standard glass cloths according to a generally used production process. The properties of copper-clad laminate e are shown in table 1.

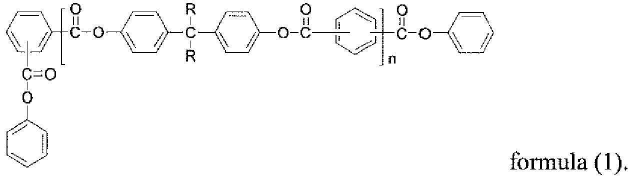

The test results of products of examples and comparative examples are shown in table 1 below.

**Table 1 Comparison of properties of the above copper clad laminates**

| Test Items | Copper-clad laminate a | Copper-clad laminate b | Copper-clad laminate c | Copper-clad laminate d | Copper-clad laminate e |
|---|---|---|---|---|---|
| Tg(DSC) (°C) | 156 | 157 | 154 | 145 | 135 |
| T-peeling strength (kg/mm²) | 1.85 | 1.85 | 1.88 | 1.74 | 1.69 |
| Peeling strength (kg/mm²) | 1.64 | 1.65 | 1.70 | 1.55 | 0.82 |
| Saturated water absorption (%) | 0.33 | 0.31 | 0.31 | 0.22 | 0.60 |
| Thermal decomposition temperature (°C) | 395 | 396 | 395 | 356 | 392 |
| Bending strength | 11.8 | 12.2 | 12.3 | 10.0 | 10.9 |
| (kg/mm²) | | | | | |
| Combustibility (UL-94) | V-0 | V-0 | V-0 | V-0 | V-1 |
| Dielectric constant (1GHz) | 3.20 | 3.18 | 3.22 | 3.00 | 3.70 |
| Dielectric loss (1GHz) | 0.0050 | 0.0052 | 0.0055 | 0.0040 | 0.014 |

Test methods for the above characteristics are as follows:

### (1) Water absorption

A 100 mm x 100 mm × 1.6 mm sample was placed in an oven at 105 °C to dry for 1 h, and was weighted after cooling and then was steamed under a vapor pressure of 105 kPa for 120 min, and finally was dried and weighted, and then the water absorption thereof was calculated.

### (2) Glass transition temperature Tg

A sample with a width of about 8-12 mm and a length of 60 mm was prepared and the glass transition temperature Tg thereof was measured on NETZSCH DMA Q800 by setting the measurement mode as bending mode and the scanning temperature as from room temperature to 200°C, and by reading the corresponding temperature at which the loss tangent value was maximum.

### (3) Bending strength

A 25.4 mm × 63.5 mm sample was prepared, and the thickness thereof was measured using a vernier caliper, and the bending strength thereof was measured on universal material testing machine by adjusting the test mode as bending test mode, the space as 15.9 mm, and the test speed as 0.51 mm/min. An average value of three parallel tests was taken, and the test temperature was room temperature and 180°C respectively.

### (4) Peeling strength

The copper-clad laminate was cut into a 100 mm × 3 mm test piece. The peeling strength of copper foil and resin was measured by stripping the copper foil and delaminating it at a speed of 50.8 mm/min using peeling resistance testing device. A larger value represents a better adhesive force between resin and copper foil.

### (5) Combustibility

The combustibility was tested according to standard ANSL UL94-1985.

### (6) Dielectric constant and dielectric loss

Dielectric constant and dielectric loss was tested according to standard ASTM D150.

The applicant states that, the present invention describes the detailed technological equipment and process by the aforesaid examples, but the present invention is not limited to the aforesaid detailed technological equipment and process. That is to say, it does not mean that the present invention cannot be fulfilled unless relying on the aforesaid detailed technological equipment and process. Those skilled in the art shall know that, any modification to the present invention, any equivalent replacement of each raw material of the product of the present invention and the addition of auxiliary ingredient, the selection of specific embodiment and the like all fall into the protection scope and the disclosure scope of the present invention.

## Claims

1. A phosphazene compound containing ester group, **characterized in that** it has a structure of formula (I): 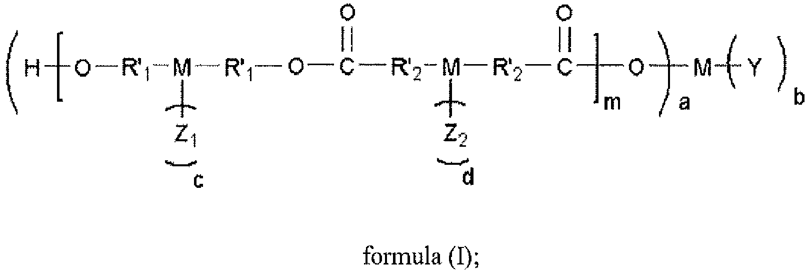
in formula (I), Y, Z₁ and Z₂ are inert nucleophilic groups;
M is any one of phosphazene compounds or a combination of at least two of them;
R'₁ is -X-R'₃-; R'₂ is -X-R'₄-; R'₃ and R'₄ are organic groups having two broken bonds; X is oxygen atom, nitrogen atom or sulfur atom;
a is an integer greater than or equal to 1; b is an integer greater than or equal to 0; c is an integer greater than or equal to 0; d is an integer greater than or equal to 0; the sum of b and a is two times of the number of phosphorus atoms in M; the sum of c+2 is two times of the number of phosphorus atoms in M; the sum of d+2 is two times of the number of phosphorus atoms in M; m is an integer less than or equal to 10.

2. The phosphazene compound containing ester group of claim 1, **characterized in that** it has a structure of formula (II): 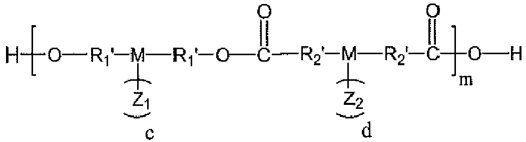 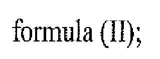
in formula (II), Z₁ and Z₂ are inert nucleophilic groups;
M is any one of phosphazene compounds, or a combination of at least two of them;
R'₁ is -X-R'₃-; R'₂ is -X-R'₄-; R'₃ and R'₄ are organic groups having two broken bonds; X is oxygen atom, nitrogen atom or sulfur atom;
c is an integer greater than or equal to 0; d is an integer greater than or equal to 0; the sum of c+2 is two times of the number of phosphorus atoms in M; the sum of d+2 is two times of the number of phosphorus atoms in M; m is an integer greater than 0 and less than or equal to 10.

3. The phosphazene compound containing ester group of claim 2, **characterized in that** Z₁ and Z₂ are independently selected from any one of -OR₁₄, 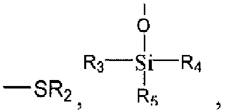 -C≡C-R₆ 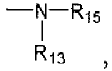 -O-NO₂, -I or 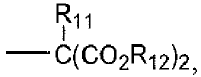 or a combination of at least two of them;
R₁₄, R₁₃, R₂, R₃, R₄, R₅, R₆, R₁₅, R₁₁ and R₁₂ are independently any one of substituted or unsubstituted linear alkyl or branched alkyl, substituted or unsubstituted cycloalkyl, substituted or unsubstituted aralkyl, substituted or unsubstituted alkoxy, substituted or unsubstituted alkylthio group, substituted or unsubstituted cycloalkoxy, substituted or unsubstituted arylalkoxy, substituted or unsubstituted alkylaryloxy, substituted or unsubstituted carbonate group, substituted or unsubstituted sulfonate group, substituted or unsubstituted phosphonate group, substituted or unsubstituted aryl, or substituted or unsubstituted heteroaryl;
preferably, M is selected from cyclic phosphazene having a structure of formula (III), or linear phosphazene having a structure of formula (IV); 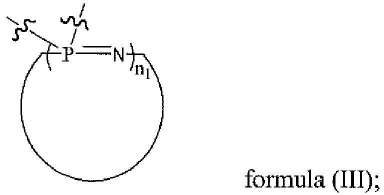 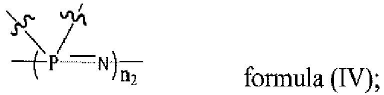 in formula (III) or formula (IV), n₁ and n₂ are independently selected from integers of 3-10; n₁ is preferably 3 or 4, and n₂ is preferably 5, 6, 7 or 8;
preferably any one of cyclotriphosphazene group M₁, cyclotetraphosphazene group M₂, or non-cyclic polyphosphazene group M₃, or a combination of at least two of them;
preferably, R'₃ is selected from substituted or unsubstituted hydrocarbylene, and preferably selected from substituted or unsubstituted linear alkylene, substituted or unsubstituted branched alkylene, substituted or unsubstituted arylene; more preferably C₁-C₃₀ substituted or unsubstituted linear alkylene, C₁-C₃₀ substituted or unsubstituted branched alkylene, and C₆-C₃₀ substituted or unsubstituted arylene; in particular preferably C₁-C₁₀ substituted or unsubstituted linear alkylene, C₁-C₁₀ substituted or unsubstituted branched alkylene, and C₆-C₁₆ substituted or unsubstituted arylene; in particular preferably phenylene, methylphenylene, dimethylphenylene, ethylphenylene, 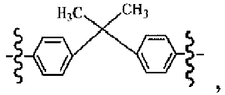 methylene, ethylene, propylene, n-butylene, or isopropylene.

4. The phosphazene compound containing ester group of claim 2, **characterized in that** the phosphazene compound containing ester group comprises any one of the phosphazene compounds having the following structures, or a mixture of at least two of them: 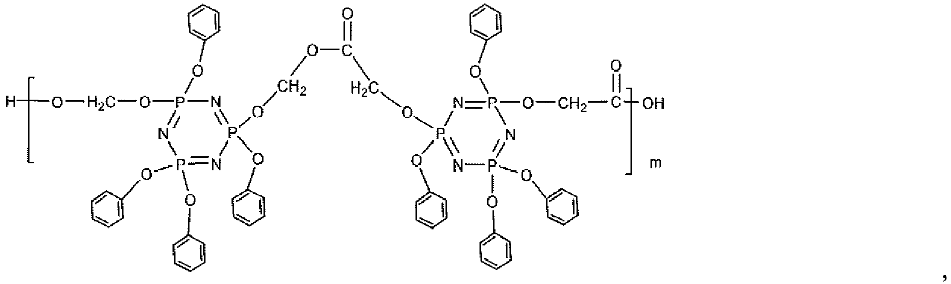 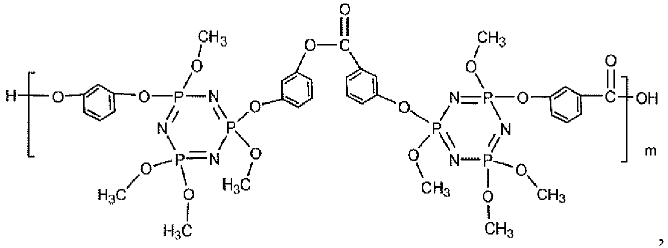 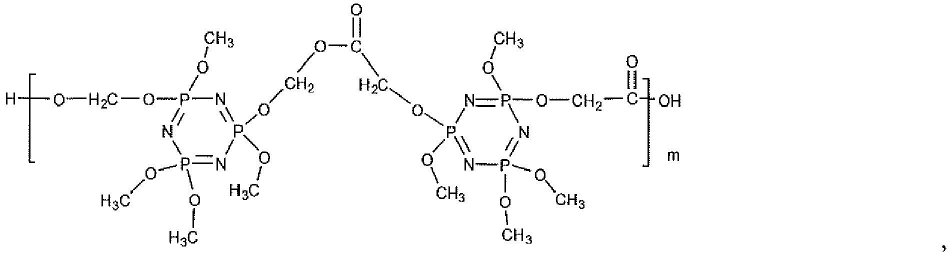 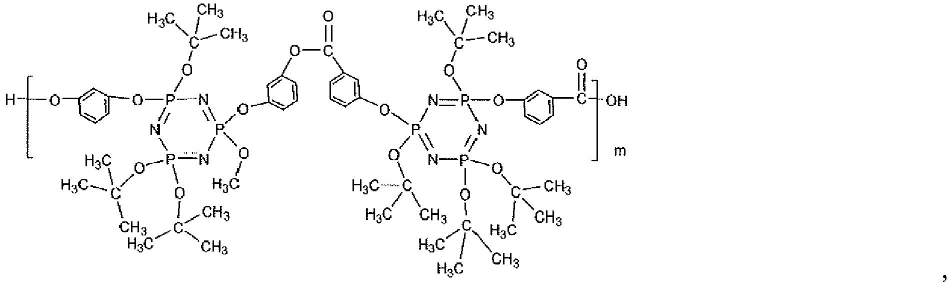 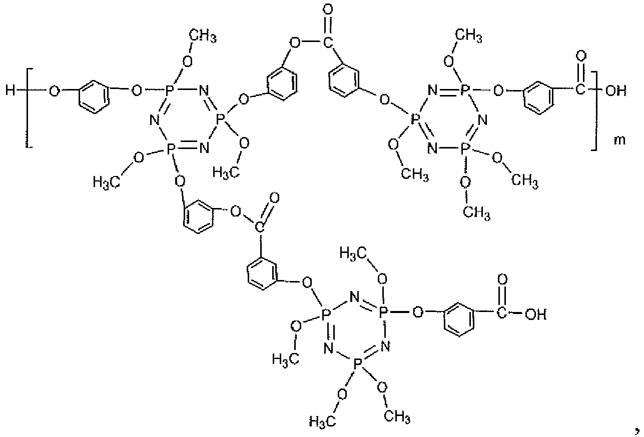 wherein m is an integer greater than 0 and less than or equal to 10.

5. A method for preparing the phosphazene compound containing ester group of any one of claims 2-4, **characterized in that** it comprises the following steps:
(1) carrying out a nucleophilic reaction of phosphazene chloride M-(-Cl)_{c+2} with an inert nucleophile, thereby replacing partial chlorine atoms on M by inert nucleophilic groups, with two remaining chlorine atoms on the phosphazene chloride being not replaced;
(2) dividing the product obtained in step (1) into two equal parts in mole, with one part being reacted with H-X-R'₃-OH to relapce the remaining chlorine atoms on phosphazene matrix by -R'₁-OH, and the other part being reacted with H-X-R'₄-COOH to replace the remaining chlorine atoms on phosphazene matrix by -R'₂-COOH; and
(3) carrying out esterification reaction of the phosphazene compound having hydroxyl groups with the phosphazene compound having carboxyl groups obtained in step (2), thereby obtaining a phosphazene compound containing ester group;
wherein M, X, R'₁, R'₂, R'₃ and R'₄ have scopes as defined in any one of claims 2-4.

6. A resin composition, **characterized in that** it comprises the phosphazene compound containing ester group of any one of claims 2-4.

7. A prepreg, **characterized in that** it is prepared by impregnating a substrate with the resin composition of claim 6 or coating the resin composition of claim 6 onto a substrate;
preferably, the substrate is a glass fiber substrate, a polyester substrate, a polyimide substrate, a ceramic substrate or a carbon fiber substrate.

8. A composite metal laminate, **characterized in that** it comprises at least one sheet of the prepreg described in claim 7 and is prepared by coating metal layer on the surface of the prepregs, overlapping and pressing successively;
preferably, the material of the surface-coating metal layer is aluminium, copper, iron and alloys of any combination thereof;
preferably, the composite metal laminate is CEM-1 copper-clad laminate, CEM-3 copper-clad laminate, FR-4 copper-clad laminate, FR-5 copper-clad laminate, CEM-1 aluminum-clad laminate, CEM-3 aluminum-clad laminate, FR-4 aluminum-clad laminate or FR-5 aluminum-clad laminate.

9. A wiring board, **characterized in that** it is prepared by processing wirings on the surface of the composite metal laminate of claim 8.

10. A flexible copper-clad laminate, **characterized in that** it comprises at least one prepreg of claim 7 and copper foil overlaying at one side or both sides of the superimposed prepregs.

11. A use of the phosphazene compound containing ester group of any one of claims 2-4, **characterized in that** it is used in IC package board, HDI package board, automotive board or copper-clad laminate.
